# EUROPEAN PATENT SPECIFICATION

(11) **EP 4 369 086 B1**
(45) Date of publication and mention of the grant of the patent: **12.08.2026**
(21) Application number: 23208189.3
(22) Date of filing: 07.11.2023
(51) Int. Cl.: G02F 1/1333, B60K 35/22, B60K 37/20

(54) **DISPLAY APPARATUS**
ANZEIGEGERÄT
APPAREIL D'AFFICHAGE

(30) Priority: 10.11.2022 KR 20220149831
(43) Date of publication of application: 15.05.2024
(73) Proprietor: LG Display Co., Ltd., Seoul 07336 (KR)
(72) Inventor: JANG, Sangho, 10845 Paju-si, Gyeonggi-do (KR)
(74) Representative: Viering, Jentschura & Partner mbB Patent- und Rechtsanwälte

(56) References cited:
- KR-A- 20100 117 719
- US-A1- 2017 176 806

## Description

### BACKGROUND OF THE INVENTION

### Field of the Invention

This disclosure relates to a display apparatus, and more specifically, to a display apparatus capable of dispersing and alleviating the stress generated during the fastening of a set frame and a core plate, thereby reducing the unevenness and warping of a cover glass.

### Description of the Related Art

Recently, rapid advance of the field of displays for visually representing electrical information signals has led to developments of various display apparatuses with excellent performance in terms of compactness, lightweight, and low power consumption.

Liquid crystal display (LCD) apparatuses and organic light emitting display (OLED) apparatuses are represented examples of display apparatuses.

Among them, self-luminous display apparatuses such as organic light emitting display apparatuses are being considered as competitive applications for achieving compactness and vivid color display without requiring a separate light source. Display apparatuses are equipped with self-light emitting components at each sub-pixel, where the light-emitting component consists of two electrodes facing each other and a light emitting layer interposed between them, emitting light when transported electrons and holes recombine.

Display apparatuses may include a display panel and several other components to provide various functions. For example, the display assembly may include one or more display-driving circuits for controlling the display panel. Examples of driving circuits include gate drivers, light-emitting (source) drivers, power (VDD) routers, electrostatic discharge (ESD) circuits, multiplex (MUX) circuits, data signal lines, cathode contacts, and other functional elements.

The display assembly may also include multiple peripheral circuits to provide various additional functions, such as touch sensing or fingerprint identification. Some components can be placed on the display panel itself, while others can be placed on films or circuit boards disposed outside the display panel.

Organic light-emitting display apparatuses have the advantage of being able to be made into thin film devices using a light-emitting layer between electrodes. Additionally, since they do not require separate light sources, organic light-emitting display apparatuses are well-suited for being designed into various forms such as flexible, bendable, and foldable display apparatuses.

Display apparatuses such as organic light-emitting display apparatuses, which include spontaneous light-emitting components, are expanding their scope of application to various fields, such as traditional electronic devices like televisions (TVs), as well as car instrument panels, windshields, mirror displays, indoor and outdoor signage, and more. Such display apparatuses require optimization to suit their usage environment.

With the advent of the era of electric vehicles, many car manufacturers are equipping their electric cars with display apparatuses such as LCD and OLED to display various vehicle operation information. However, there are known drawbacks and disadvantages with conventional display devices mounted in vehicles.

For example, when installing the display apparatus in a vehicle, the core plate and the set frame fixed with fasteners to the dashboard or other internal structural components of the vehicle, and may extend to the area in front of the driver's seat or the front passenger's seat inside the vehicle. As will be described further below, such fastening, typically with screws, often leads to warping or unevenness of the display generally, and more specifically, the cover glass. The warping and unevenness may be localized near the location of the fasteners and can compromise the display, while also creating a risk of touch malfunctions when the display is a touch screen device. Thus, it would be advantageous to have a display device that overcomes the deficiencies and disadvantages of conventional displays.

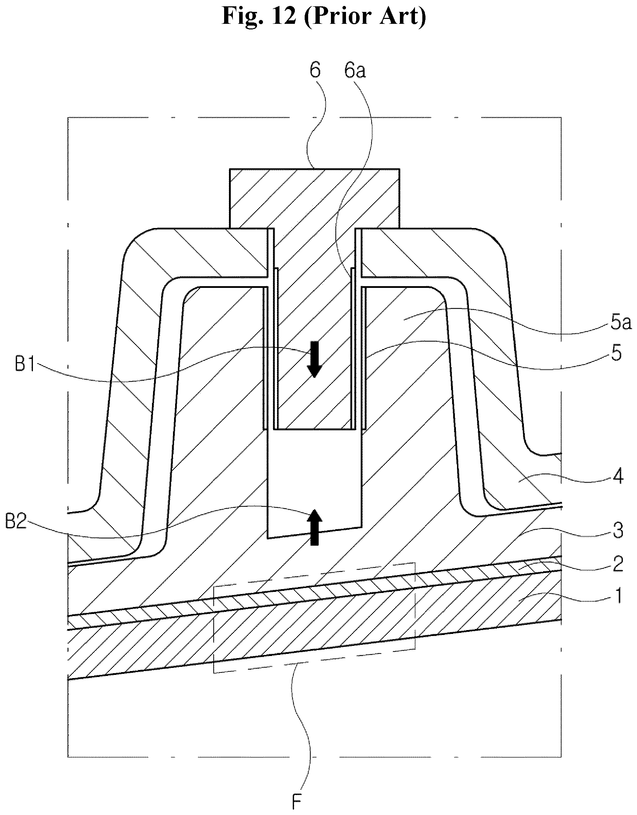

FIG. 12 shows the fastening structure between the core plate 4 and the set frame 3 of a conventional display device and is provided as background for the advantages and benefits of the techniques of the present disclosure. The front surface of the set frame 3 may be bonded to the cover glass 1 via resin 2. The back surface of the set frame 3 may be fastened to the core plate 4 via bolts 6 through the bolt holes 5 formed in the joint portions 5a of the set frame 3. The bolts 6 are machined with threads 6a and fastened to the threaded holes 5 by screwing them in. In other words, as the bolts 6 are screwed in, they apply a force B1 to the set frame 3 that results in a force B2 applied to the cover glass 1, where the force B2 is generally an upward vertical force (in the orientation of FIG. 12) that tends to distort the cover glass 1.

Here, the bolts 6 are screwed in, applying a force B1 that pulls the joint portions 5a together. In this case, since the joint portions 5a are parts of the set frames 3, stress B2 is generated in the direction of the bolts 6 at the area corresponding to the joint portions 5a on the set frame 3.

As described above, since the set frame 3 is bonded to the cover glass 1 via resin 2, stress is generated to the F region of the cover glass 1, which corresponds to the fastening area in the direction of the bolts, resulting in deformation.

Strong screw fastening is required to ensure secure fixation of the display apparatus, but this can result in excessive stress B2 on the set frame 3, leading to warping or unevenness of the cover glass 1 that protects the display panel. Such warping or unevenness particularly occurs at the area where the screws are fastened, which is typically the edge of the cover glass 1. This can compromise the appearance and pose a risk of touch malfunctions.

Further to the above, US 2017 / 176 806 A1 discloses a display device includes a display panel, a cover, a bonding member, a guide mold and at least one fastening member. The cover is above the display panel. The bonding member is on a surface of the cover and includes a plurality of non-recessed portions and a plurality of recessed portions between the plurality of non-recessed portions. The guide mold accommodates a light source below the display panel and includes a plurality of protruding portions protruding from a side surface thereof, each of the plurality of protruding portions respectively corresponding to each of the plurality of non-recessed portions. The at least one fastening member penetrates a corresponding one of the plurality of protruding portions of the guide mold to be fastened to a corresponding one of the plurality of recessed portions.

### SUMMARY OF THE INVENTION

The present disclosure is provided to solve the above problems in the related technical field and aims to provide a display apparatus capable of reducing warping or unevenness of the cover glass by dispersing and alleviating stress generated during the fastening of the set frame and core plate.

In order to accomplish the above object, in an aspect of this disclosure, there is provided a display apparatus according to claim 1. Further embodiments are described in the dependent claims and as further below.

Also, in an embodiment of this disclosure, the stress-free space is connected to a fastening hole formed in the fastening member.

Also, in an embodiment of this disclosure, the upper flange is connected to a lower portion of the fastening member and expanded outward in a radial direction from the fastening member, and the expansion member may include a side flange connecting the lower portion of the upper flange and the set frame.

Also, in an embodiment of this disclosure, the expansion member may be formed in a cylindrical shape.

Also, in an embodiment of this disclosure, the stress-free space may be formed inside in a circular or polygonal shape.

Also, in an embodiment of this disclosure, the stress dispersion unit may further include a protrusion arranged radially and protruding outward from the side flange.

Also, in an embodiment of this disclosure, the core plate further may include a protruding block connected to a lower portion of the coupling block, protruding toward the side flange, and arranged on a lower portion of the protrusion.

Also, in an embodiment of this disclosure, the core plate may further include an extension block connected to a lower portion of the coupling block and arranged to enclose the upper flange and the side flange.

Also, in an embodiment of this disclosure, the display apparatus may further include an adhesive member arranged between the cover member and the set frame and bonding the cover member and the set frame.

Also, in an embodiment of this disclosure, the cover member may include an active area corresponding in position to the display panel and a non-active area outside the active area and the adhesive member is arranged in the non-active area.

Also, in an embodiment of this disclosure, the fastening member and the coupling block may be arranged in the non-active area.

Also, in an embodiment of this disclosure, the adhesive member may include a non-adhesive area corresponding in shape to an interior shape of the stress-free space. For example, the non-adhesive area may be formed by cutting off the adhesive member.

According to this disclosure, it is possible to alleviate the warping or unevenness of the cover glass, which occurs due to stress generated during the fastening of the set frame and core plate, by dispersing and alleviating the stress.

It is also possible to improve visibility by reducing the distortion of the front screen of the vehicle. It is also possible to enhance the appearance of the front screen of the vehicle.

It is also possible to prevent touch-responsive malfunctions and deterioration of the displayed image quality.

### BRIEF DESCRIPTION OF THE DRAWINGS

FIG. 1 is a front view of a display apparatus according to an embodiment of this disclosure;
FIG. 2 is a rear view of a display apparatus according to an embodiment of this disclosure;
FIG. 3 is an exploded view of a display apparatus according to an embodiment of this disclosure;
FIG. 4 is a cross-sectional view of a light emitting component according to an embodiment of this disclosure;
FIG. 5 is a perspective view of a stress dispersing unit according to an embodiment of this disclosure;
FIG. 6 is a cross-sectional view of the stress dispersing unit according to an embodiment of this disclosure.
FIG. 7A is a side cross-sectional view illustrating a structure of a stress dispersing unit and a core plate according to a first embodiment of this disclosure;
FIG. 7B is a side cross-sectional view illustrating a structure of a stress dispersing unit and a core plate according to a second embodiment of this disclosure.
FIG. 7C is a side cross-sectional view illustrating a structure of a stress dispersing unit and a core plate according to a third embodiment of this disclosure;
FIGS. 8A to 8D are diagrams illustrating various forms of an expansion member of a stress dispersing unit according to an embodiment of this disclosure;
FIGS. 9A to 9D are diagrams illustrating various shapes of a portion of an adhesive member that corresponds to an expansion member according to an embodiment of this disclosure;
FIG. 10A is a diagram illustrating stress distribution in the cover glass when a conventional set frame and core plate are fastened.
FIG. 10B is a diagram illustrating stress distribution in the cover glass when a set frame and core plate are fastened according to an embodiment of the present disclosure.
FIG. 11A is a diagram illustrating stress distribution formed at the fastening area along the edge of a conventional cover glass;
FIG. 11B is a diagram illustrating stress distribution formed at the fastening area along the edge of the cover glass according to an embodiment of this disclosure.
FIG. 12 is a cross-sectional view illustrating a fastening structure between a conventional core plate and set frame.

### DETAILED DESCRIPTION OF THE INVENTION

The advantages and features of this disclosure and methods of accomplishing the same will become clear by reference to the detailed description of embodiments that will be made hereinafter with reference to the accompanying drawings. The disclosed invention may, however, be embodied in many different forms and should not be construed as being limited to the embodiments set forth herein; rather, these embodiments are provided so that this disclosure will be thorough and complete and will fully convey the concept of the invention to those skilled in the art, and the present invention will only be defined by the appended claims.

The shapes, sizes, ratios, angles, numbers and the like illustrated in the drawings to describe embodiments of this disclosure are merely exemplary, and thus, this disclosure is not limited thereto. Throughout the specification, the same reference numerals refer to the same components. In addition, detailed descriptions of well-known technologies may be omitted in this disclosure to avoid obscuring the subject matter of the disclosure. When terms such as "comprises," "has," "includes," or "is made up of" are used in this specification, it should be understood that unless "only" is specifically used, additional elements or steps can be included. Unless otherwise explicitly stated, when a component is expressed in the singular form, it is intended to encompass the plural form as well.

In interpreting the components, it is construed to include a margin of error even in the absence of explicit description.

When describing the positional relationship, for example, when the relationship between two parts is described as "on," "on top of," "undemeath," "beside," etc., unless "directly" or "immediately" is used, one or more other parts may be located between the two parts.

When a device or layer is referred to as being "on" another device or layer, it includes cases where one device or layer is directly located on the other device or layer or still other device or layer is interposed between the two devices or layers.

Although the terms "first," "second," and the like are used to describe various components, these components are not limited by these terms. These terms are merely used for distinguishing one component from the other components. Therefore, the first component mentioned hereinafter may be the second component in the technical sense of this disclosure.

Throughout the specification, the same reference numerals refer to the same components.

The sizes and thicknesses of the components depicted in the drawings are provided for descriptive convenience and should not be interpreted as limiting the scope of the disclosure.

The features of various embodiments of this disclosure can be partially or entirely combined or assembled in various technical manners of interlocking and interoperation obvious to those skilled in the art, and each embodiment can be implemented independently or in combination with related embodiments.

Hereinafter, detailed descriptions are made of the embodiments of this disclosure with reference to the accompanying drawings.

In this disclosure, the term "display apparatus" is used in a narrow sense to refer to display apparatuses, such as a liquid crystal module (LCM), an organic light-emitting diode (OLED) module, and a quantum dot module, each including a display panel and a panel driving unit to operate the display panel. It is also possible to include set electronic devices or set device or apparatuses such as equipment displays, including complete or final products such as laptop computers, televisions, computer monitors, automotive displays or equipment displays provided in other forms for vehicles, as well as mobile electronic devices such as smartphones or electronic pads that include LCMs, OLED modules, QD modules, and the like.

Accordingly, in this disclosure, the display apparatus may include not only the display apparatuses in the narrow sense themselves, such as LCMs, OLED modules, QD modules, but also set devices as application products or final consumer devices each including LCMs, OLED modules, QD modules, and the like.

Additionally, in some cases, an LCM, an OLED module, or a QD module, composed of a display panel and a panel driving unit may be referred to as "display apparatus" in a narrow sense, while an electronic device as a complete product including an LCM, an OLED module, or a QD module may be referred to as "set device." For example, the narrow-sense display apparatus may include a display panel of liquid crystal (LCD), organic light-emitting diode (OLED), or quantum dot (QD) and a source printed circuit board (PCB) as a control unit for driving the display panel, while a set device may further include a set PCB, serving as a set control unit that is electrically connected to the source PCB and controls the entire set device.

The display panel used in this embodiment may include all types of display panels such as liquid crystal display panels, organic light-emitting diode (OLED) display panels, quantum dot (QD) display panels, and electroluminescent display panels, and is not limited to a specific display panel capable of bending a bezel with a flexible substrate for an OLED display panel of this embodiment and a backplane support structure thereunder. In addition, the display panel used in the embodiments of this specification is not limited to the shape or size of the display panel.

For example, when the display panel is an organic light-emitting diode (OLED) display panel, it may include a plurality of gate lines and data lines and pixels formed at the intersection of the gate lines and data lines. In addition, it may be configured to include an array including thin-film transistors as components for selectively applying a voltage to each pixel, an organic light-emitting diode (OLED) layer on the array, an encapsulation substrate or encapsulation layer arranged on the array to cover the organic light-emitting diode layer, etc.

The encapsulation layer may protect the thin film transistors and the organic light-emitting device layer from external impacts and prevent moisture or oxygen from penetrating into the organic light-emitting device layer. In addition, the layers formed on the array may include an inorganic light-emitting layer, such as a nano-sized material layer or quantum dots, for example.

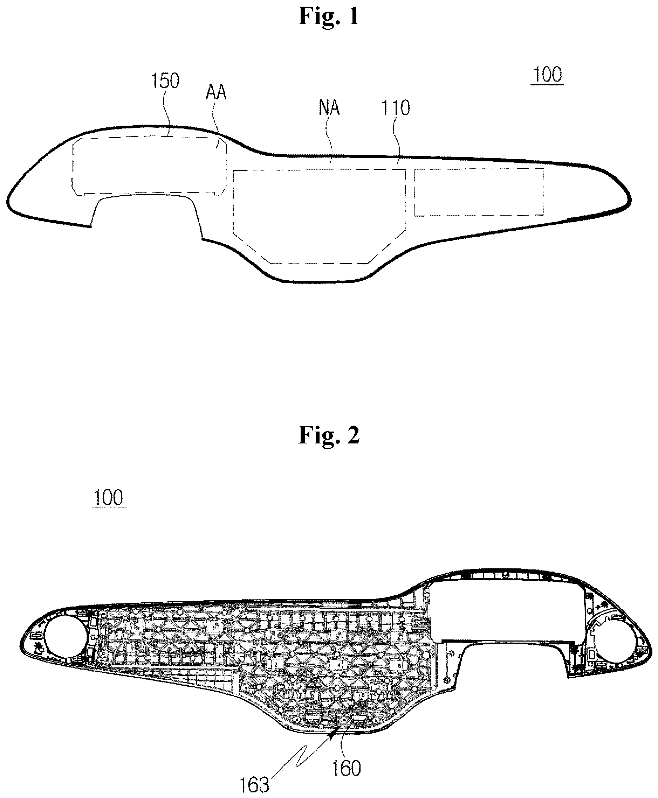

In this disclosure, FIG. 1 illustrates an exemplary organic light emitting diode (OLED) display panel that may be integrated within the display apparatus, but as noted above, embodiments of the disclosure are not limited to OLED display panels.

FIG. 1 is a diagram illustrating a display apparatus according to an embodiment of this disclosure.

With reference to FIG. 1, the display apparatus 100 may be applied to the center fascia of a vehicle or may otherwise be fixed to an intemal structural frame of a vehicle and provided to display images to a user. Although FIG. 1 shows a rectangular display panel 150, the shape of the display apparatus 100 is not necessarily limited thereto and can be produced in various shapes such as squares, polygons, circles, ovals, or curves.

With reference to FIG. 1, the display apparatus 100 is equipped with integrated display and touch functions, and the cover member 110 is attached to the front. A display panel 150 for displaying may be arranged on the back surface of the cover member 110. The display apparatus 100 may be inserted and coupled to the dashboard of a vehicle. The display panel 150 may be made on a substrate of a rigid material, but in the case of organic light-emitting devices, it may also be made on a flexible substrate. A display panel 150 made on a flexible substrate may be deformed concavely or convexly depending on the shape of the dashboard, allowing for a flexible design. The cover member 110 may be a cover glass.

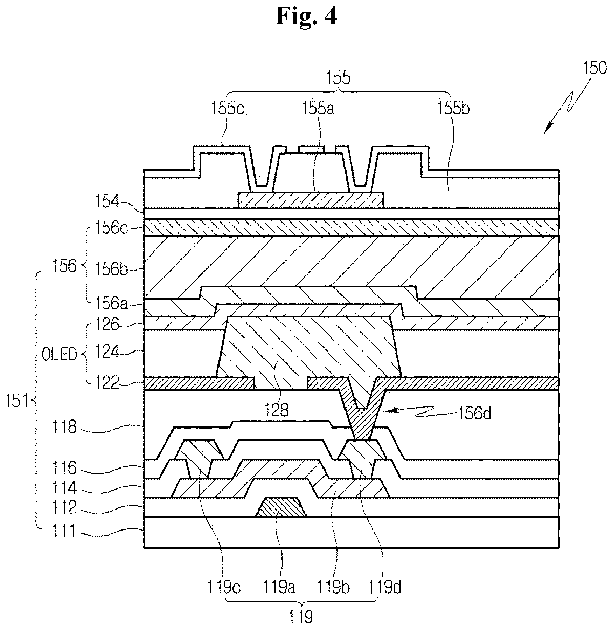

FIG. 4 shows the cross-sectional structure of the light-emitting component provided in the display panel 150 of FIG. 1. The substrate 111 may support various components of the display panel 150. The substrate 111 may be formed of a transparent dielectric material such as glass, plastic, and the like. In the case of being made of plastic, the substrate 111 may be a plastic film or a plastic substrate. For example, the substrate 111 may take the form of a film including one of polyimide-based polymers, polyesters-based polymers, silicone-based polymers, acrylic-based polymers, polyolefin-based polymers, and their copolymers. Among these materials, polyimide is mainly used as a plastic substrate because it is suitable for high-temperature processes and is a material that can be coated.

A buffer layer (not shown) may be positioned on the substrate 111. The buffer layer is a functional layer that protects the thin film transistor (TFT) from impurities such as alkali ions that may leak from the bottom of the substrate 111. The buffer layer may be formed of silicon oxide (SiOx), silicon nitride (SiNx), or multiple layers thereof.

A thin film transistor 119 may be disposed on the buffer layer and/or the substrate 111. The thin film transistor 119 may be formed by sequentially arranging a gate electrode 119a, a gate insulating layer 112, a semiconductor layer 119b, an interlayer insulating film 114, and source and drain electrodes 119c and 119d. There may be one or more thin film transistors 119 arranged for a plurality of sub-pixels provided in the active area of the display panel 150.

Although illustrated as the bottom-gate type in FIG. 4, the thin film transistor 119 is not limited thereto and may also be provided as the top-gate type, in which the order of the semiconductor layer 119b and the gate electrode 119a are reversed.

The semiconductor layer 119b may be arranged at a specific portion on the substrate 111 or the buffer layer. The semiconductor layer 119b may be made of polycrystalline silicon (p-Si), and in this case, a region of the semiconductor layer 119b may be doped with impurities to form the electrode layer. The semiconductor layer 119b may also be made of amorphous silicon (a-Si) and various organic semiconductor materials such as pentacene. Furthermore, the semiconductor layer 119b may also be made of an oxide material. The gate insulating layer 112 may be formed of inorganic dielectric materials such as silicon oxide (SiOx) or silicon nitride (SiNx) and, organic dielectric materials. The gate electrode 119a may be formed of various conductive materials, such as magnesium (Mg), aluminum (Al), nickel (Ni), chromium (Cr), molybdenum (Mo), tungsten (W), gold (Au), or alloys thereof.

The first interlayer insulating film 114 may be formed of inorganic dielectric materials such as silicon oxide (SiOx) or silicon nitride (SiNx), organic dielectric materials. The first interlayer insulating film 114 may be selectively removed to form contact holes exposing the source and drain regions.

The source and drain electrodes 119c and 119d are formed as a single layer or multilayer electrode material on the first interlayer insulating film 114.

An inorganic protective film 116 and a planarization layer 118 may be positioned on the thin film transistor 119 to cover the source and drain electrodes 119c and 119d. The inorganic protective film 116 and the planarization layer 118 protect the thin film transistor 119 and flatten its upper surface.

The inorganic protective film 116 may be formed of inorganic dielectric films such as silicon nitride (SiNx) and silicon oxide (SiOx), while the planarization layer 118 may be made of organic dielectric films such as Benzocyclobutene (BCB) or acrylic (Acryl). The inorganic protective film 116 and the planarization layer 118 may each be formed as a single-layer, dual-layer, or multilayer structure, and in some cases, one of the two layers may be omitted.

A light-emitting component OLED connected to the thin film transistor (TFT) 119 may be formed by sequentially arranging a first electrode 122, an organic light-emitting layer 124, and a second electrode 126. That is, the light-emitting component OLED may be composed of the first electrode 122 connected to the drain electrode 119d through the via hole 156d formed in the planarization layer 118 and the inorganic protective film 116, the organic light emitting layer 124 positioned on the first electrode 122, and the second electrode 126 positioned on the organic light-emitting layer 124.

When the display panel 150 is of a top emission type where the emission occurs upward through the second electrode 126, the first electrode 122 may include an opaque conductive material with high reflectivity. In this case, examples of reflective conductive material may include silver (Ag), aluminum (Al), gold (Au), molybdenum (Mo), tungsten (W), chromium (Cr), or alloys thereof.

A bank 128 is formed in the area excluding the light-emitting area, opening up the light-emitting area. Accordingly, the bank 128 has a bank hole exposing the first electrode 122 corresponding to the light-emitting area. The bank 128 may be made of inorganic dielectric materials such as silicon nitride (SiNx), silicon oxide (SiOx), or organic dielectric materials such as BCB, acrylic-based resins, or imide-based resins.

The organic light-emitting layer 124 is positioned on the first electrode 122 exposed by the bank 128. The organic light-emitting layer 124 may include a hole injection layer, a hole transport layer, an emissive layer, an electron transport layer, and an electron injection layer. In addition, the organic light-emitting layer 124 may be composed of a single emissive layer structure that emits a single light within a single stack, or a multi-stack structure including multiple stacks, each of which includes a single emissive layer of the same color. In such cases, adj acent sub-pixels may be arranged to emit different colors of light to display various colors. For example, sub-pixels with emissive layers of red, green, and blue may be arranged in a row or spaced apart from each other and, as well, in a triangle shape or pentile structure with some sub-pixels of predetermined colors aligned parallel and others aligned diagonal to each other.

In some cases, sub-pixels of white color may also be added to the arrangement. In addition, the organic light-emitting layer 124 may be configured by stacking a plurality of stacks including emissive layers emitting different colors of light to express white. In the case of expressing white with a stacked structure, separate color filters may be additionally added to each sub-pixel.

The second electrode 126 is positioned on the organic light-emitting layer 124. When the display panel 150 adopts a top emission structure, the second electrode 126 may be formed of a transparent conductive material such as Indium Tin Oxide (ITO) or Indium Zinc Oxide (IZO) or a semi-transparent metal or metal alloy such as MgAg to emit light generated in the organic light-emitting layer 124 upward through the second electrode 126.

The second electrode 126 may be arranged to reach a capping layer (not shown) of the to. The capping layer may protect the OLED and assist in the extraction of light emitted through the second electrode 126 by using a material with a high refractive index.

An encapsulation layer 156 may be disposed on the light-emitting component OLED. The encapsulation layer 156 prevents the infiltration of oxygen and moisture from the outside to prevent oxidation of the emissive and electrode materials. Exposure of OLED to moisture or oxygen may cause pixel shrinkage or the formation of dark spots, reducing the emitting area. The encapsulation layer 156 is formed by altemately stacking inorganic layers 156a and 156c made of glass, metal, aluminum oxide (AlOx), or silicon (Si) materials and an organic layer 156b that serves as a buffer relieving the stress between layers due to the bending of the display panel (100 in FIG. 1) and enhances the flattening performance. The organic layer 156b may be made of organic dielectric materials such as acrylic resin, epoxy resin, polyimide, polyethylene, or silicon oxycarbide (SiOC). Here, the first and second inorganic layers 156a and 156c serve to block the penetration of moisture or oxygen, while the organic layer 156b flattens the surface of the first inorganic layer 156a. The encapsulation layer 156 is composed of several thin film layers to increase the length and complexity of the path that moisture and oxygen must travel compared to a single layer, to make it difficult for moisture and oxygen to penetrate the light-emitting component OLED.

A protective layer (not shown) may be formed further between the light-emitting component OLED and the encapsulation layer 156 to protect the encapsulation layer 156 from being peeled off or affecting the uniformity during the manufacturing process of the encapsulation layer 156.

With reference to FIG. 4, a polarization layer 154 may be disposed on the encapsulation layer 156. The polarization layer 154 may minimize the impact of light entering the display panel 150 from external light sources on the semiconductor layer 119b or the organic light-emitting layer 124.

With reference to FIG. 4, a touch sensor layer 155 may be arranged on the polarization layer 154. The touch sensor layer 155 may be structured with the first touch electrode 155a and the second touch electrode 155c intersecting each other, allowing one electrode to receive an applied voltage signal and the other to sense the voltage signal. The first touch electrode 155a and the second touch electrode 155c may be patterned into polygonal or circular shapes on a touch insulation layer 155b to be arranged at a distance from each other.

The cover member 110 may be disposed on the touch sensor layer 155. The touch sensor layer 155 and the cover member 110 may be bonded together via an adhesive layer interposed therebetween.

With reference to FIGS. 1 to 6, the display apparatus 100 according to the embodiment of this disclosure may include display panel 150, a cover member 110, a set frame 140, a core plate 160, and a stress dispersion unit 200.

With reference to FIG. 1, the display panel 150 according to an embodiment of this disclosure may be applied to a center fascia of a vehicle and dividedly arranged to display necessary information. The display panel 150 described with reference to FIG. 4 is referenced.

The cover member 110 may be arranged on the front of the display panel 150 and may be divided into an active area AA and a non-active area NA. The active area AA may correspond to the location of the display panel 150, while the non-active area NA may refer to the area outside the active area AA and/or the area surrounding the active area AA that is not configured to display images.

With reference to FIG. 2, the core plate 160 may be arranged on the back of the cover member 110 and the set frame 140 and may have a 180coupling block 163 formed thereon. As will be described further below, the coupling block 163 is associated with a corresponding fastening member 180 of the set frame 140. In this case, the core plate 160 may include a plurality of coupling blocks 163 in positions corresponding to the non-active area NA of the cover member 110 on the core plate 160.

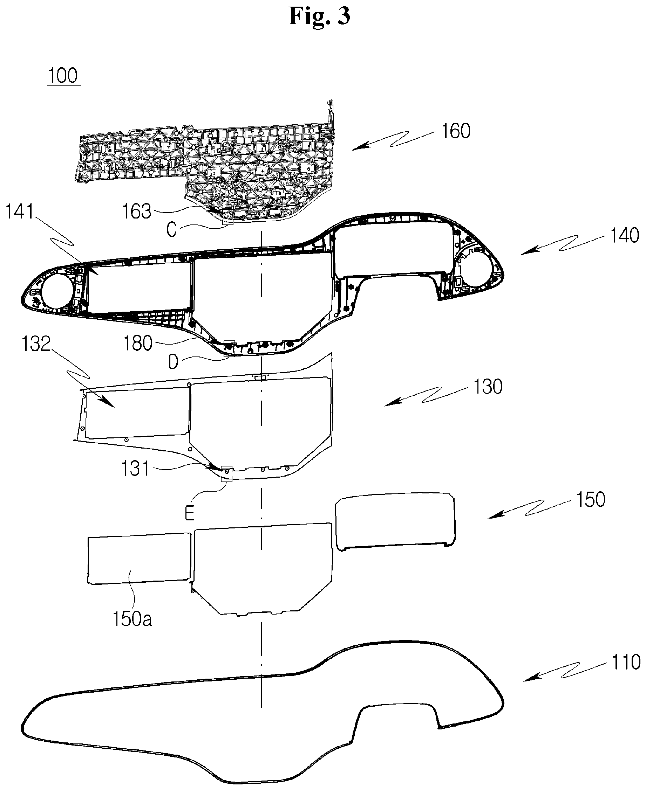

With reference to FIG. 3, the display apparatus 100 according to an embodiment of this disclosure may include the cover member 110 shaped to correspond to the center fascia shape of a vehicle and disposed on the frontmost side and the display panel 150 arranged dividedly on the back surface of the cover member 110. It means that the display panel 150 may be divided or separated into several separate and distinct display panel portions that collectively define the display panel 150. In the non-limiting example provided in FIG. 3, the display panel 150 includes three distinct and separate sections 150A that each have a selected shape and configuration in the overall display panel 150 and may each display different information to a user or driver of the vehicle. The display panel 150 may be selected to include more or less display panel sections 150A with different shapes and configurations than those illustrated.

To combine the set frame 140 and the cover member 110, an adhesive member 130 may be placed therebetween. In this case, the adhesive member 130 may be formed with one or more open areas (or openings 132) matching the display panel sections 150A of the display panel 150. In addition, the adhesive member 130 may be formed with an open non-adhesive area 131 in area E thereof, matching the position of the coupling block 163 shown inside area C of the core plate 160 and associated fastening member 180 described with reference to the set frame 140. The area E of the adhesive member 130 corresponding to the coupling block 163 may be provided in multiple quantities on the adhesive member 130. This means that the adhesive member 130 may include a selected number of open non-adhesive areas 131 (shown inside area E) that correspond to the coupling blocks 163 of the core plate 160 and associated fastening members of the set frame 140.

The set frame 140 may be attached to the back surface of the cover member 110 by the adhesive member 130, and may be formed to have an open area matching the position of the display panel 150 and more specifically, may include openings 141 corresponding to the display panel sections 150A of the display panel 150. In addition, the set frame 140 may be provided with the fastening member 180, at area D thereof, matching the position of the coupling block 163 of core plate 160 and the open non-adhesive area 131. The fastening member 180 in area D of the set frame 140 1 may be provided in multiple quantities on the set frame 140. This means that the number and location of fastening members 180 of the set frame 140 may correspond to the number and location of the coupling blocks 163 of the core plate 160 and the number and location of the open non-adhesive areas 131 of the adhesive member 130.

Although not shown in the drawings, a source printed circuit board and a control printed circuit board may be placed and connected to the display panel 150 in the open areas (i.e., openings 132) of the adhesive member 130 and the set frame 140, allowing for control of the display panel 150.

The core plate 160 may be arranged on the back surface of the set frame 140, and the coupling block 163 may be arranged on the core plate 160 at position C (i.e., in area C) corresponding to the fastening member 180 of the set frame 140 and the open non-adhesive area 131 of the adhesive member 130. The position C corresponding to the fastening member 180 and the non-adhesive area 131 may be provided in multiple quantities on the set frame 140.

Accordingly, the coupling block 163 of the core plate 160 and the fastening member 180 of the set frame 140 may be coupled using a fastener, such as a screw or bolt in non-limiting examples.

Here, the coupling block 163, the fastening member 180, and the non-adhesive area 131 may each be arranged in multiple quantities on positions corresponding to the non-active area NA of the cover member 110. This is to prevent any impact on the display of information of the display panel 150 even though stress is generated on the cover member 110 due to the force applied to the set frame 140 by the fastener connecting the coupling block 163 of the core plate 160 and the fastening member 180 of the set frame 140.

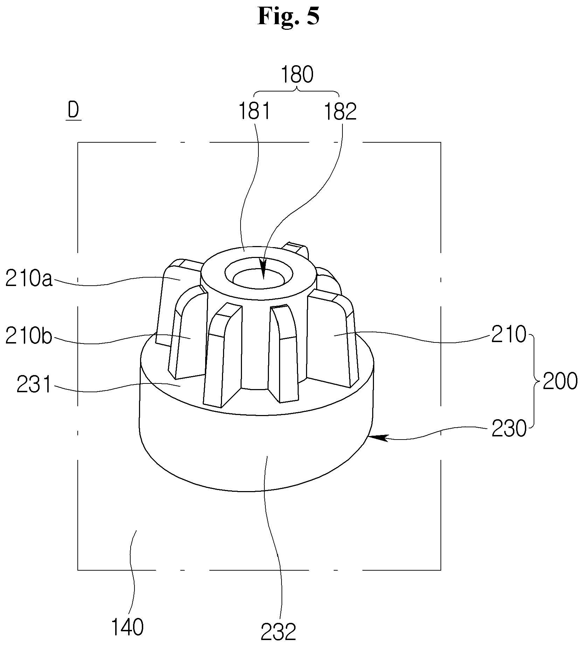

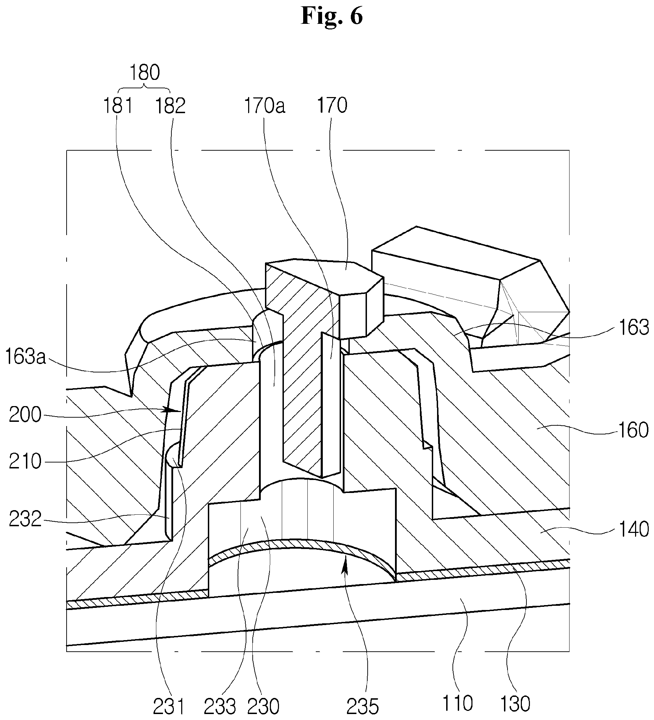

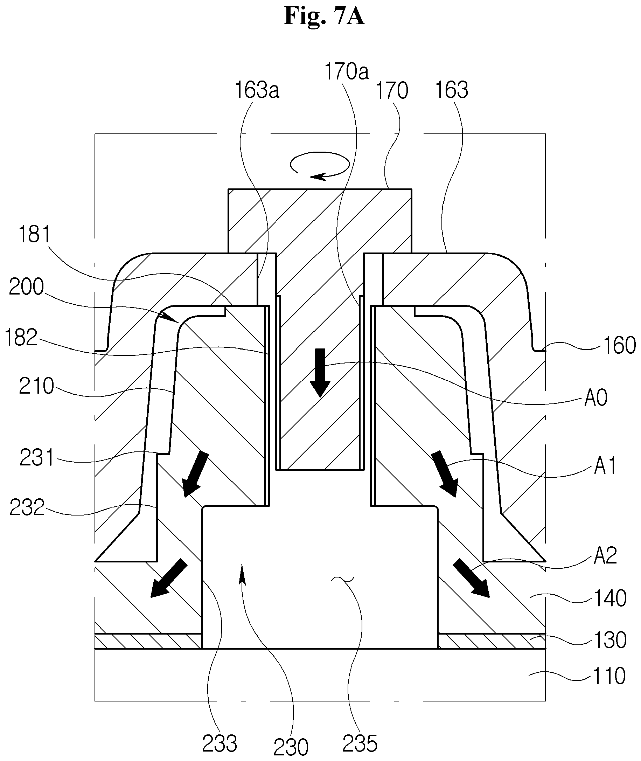

Meanwhile, FIGS. 5 to 7A illustrate the structure of the stress dispersion unit 200 and the core plate 160 according to the first embodiment. More specifically, FIG. 5 illustrates area D of the set frame 140 that includes the fastening member 180 associated with a stress dispersion unit 200. FIG. 6 is a cross-sectional view of the combination of the fastening member 180 and the stress dispersion unit 200. Figure 7A is a side cross-sectional view of the combination of the fastening member 180 and the stress dispersion unit 200 illustrating distribution of stress in the combination.

With reference to FIGS. 5 and 6, the stress dispersion unit 200 is placed on the fastening member 180 of the set frame 140 to disperse the stress applied to the cover member 110 when the fastening member 180 is fastened with the coupling block 163 of the core plate 160 using a screw or other fastener. In an embodiment, the fastening member 180 includes a body 181 and a fastening hole 182 through the body 181. The fastening member 180 may be integral with the stress dispersion unit 200 as a single, unitary structure. Alternatively, the stress dispersion unit 200 may be a separate component that receives the body 181 of the fastening member 180 during assembly of the display apparatus 100. Except as other indicated, the below description assumes that the fastening member 180 and the stress dispersion unit 200 are a single, unitary structure.

The stress dispersion unit 200 may include a supporting member 210, an expansion member 230, and a stress-free space 235.

The expansion member 230 may be disposed below, and coupled to, the body 181 of fastening member 180 and have a shape expanded outward from the body 181 of the fastening member 180. In an embodiment of this disclosure, the expansion member 230 has a cylindrical shape, but is not necessarily limited thereto.

The expansion member 230 may include an upper flange 231 and a side flange 232 which may be top and side walls of the expansion member 230, respectively.

The upper flange 231 may be connected to the lower part of the fastening member 180 and have a shape expanded outward in a radial direction from the lower part of the fastening member 180. The side flange 232 may be connected between the lower portion of the upper flange 231 and the set frame 140.

As shown in FIG. 5, the supporting member 210, which may include a plurality of supporting members 210, is disposed on the body 181 of the fastening member 180 and the upper flange 231 of the expansion member 230 of the stress dispersion unit 230. The supporting members 210 may be implemented as braces that extend from side walls of the body 181 of the fastening member 180 to the expansion member 230 of the stress dispersion unit 200. In an embodiment, each supporting member 210 is connected to, and extends over, a majority of a height of the body 181. The supporting members 210 are preferably arranged in spaced relationship to each other radially about the body 181 of the fastening member 180, as shown in FIG. 5. Such radial spacing may be equidistant, but the same is not required and the supporting members 210 can generally have a selected spacing. The supporting members 210 may each be a solid, continuous piece of material with an overall quadrilateral shape with an inner side coupled to the body 181 of the fastening member 180, a bottom side coupled to the upper flange 231 of the expansion member 230, and two outer sides that are not coupled to the body 181 and/or the expansion member 230. The outer sides may define at least one rounded outer corner.

Further, the supporting members 210 may increase in width relative to the body 181 of the fastening member 180 over the height of the supporting members 210. In other words, the supporting members 210 have a width relative to the body 181 at the interface with the upper flange 231 of the expansion member 230 (i.e., at the bottom of the supporting members 210) that is greater than a width of the supporting members 210 at the top of the supporting members 210 in the orientation of FIG. 5. Each of the supporting members 210 may have the same, or a different configuration. For example in FIG. 5, the supporting members 210 include first supporting members 210A and second supporting members 210B that are alternatively arranged in a radial direction about the body 181. The first supporting members 210A generally have a greater width relative to the body 181 (i.e., a width that approximates a width of the upper flange 231) than the second supporting members 210B. The first supporting members 210A may correspond to locations of localized stress, with the increased width assisting with distributing the higher stress over a wider area, thereby weakening the resulting stress distributed to the expansion member 230. Alternatively, it may not be necessary to include each of the supporting members 210 with a width that approximates the width of the upper flange 231 of the expansion member 230 in order to achieve the benefits described herein, in which case, the second supporting members 210B with the lesser width are provided to reduce costs and materials in manufacturing.

It is to be appreciated that the above-described features, shapes, spacing, and other characteristics of the supporting members 210 may be selected according to various design factors. For example, the supporting members 210 may have a different height and width than those illustrated, may have a different spacing, may have a different overall shape, and/or may have a different arrangement relative to the body 181 and the upper flange 231, among others. Many other configurations of the supporting members 210 are contemplated herein. Thus, the disclosure is not limited to the supporting members 210 illustrated in FIG. 5.

With reference to FIG. 6, the stress-free space 235 may be formed inside the expansion member 230 and connected to the fastening hole 182 formed in the fastening member 180. In other words, the expansion member 230 is generally hollow with the stress-face space 235 being a void or a cavity that is defined by the upper and side flanges 231, 232 of the expansion member 230. The inner surface of the fastening hole 182 may be threaded. The fastening hole 182 may receive a screw pin 170 having threads 170a machined on the outer surface thereof to couple the fastening member 180, stress dispersion unit 200, and set frame 140 together.

The supporting member 210 may be connected to the outer surface of the fastening member 180 and disposed on top of the upper flange 231. With reference to FIG. 5, the supporting member 210 may be arranged in multiple quantities along the outer circumference of the fastening member 180 in the longitudinal direction of the fastening member 180.

The coupling block 163 may protrude upward from the core plate 160 and enclose the upper part of the body 181 of the fastening member 180. The coupling block 163 may have a coupling hole 163a formed therein, through which a screw pin 170 may pass and be fastened using a screwing method, thereby connecting the core plate 160 and the set frame 140. As shown in FIG. 6, coupling block 163 is generally hollow and the fastening member 180 and the stress dispersion unit 200 are generally received inside of a cavity of the coupling block 163 with the various fastening holes align to receive screw pin 170.

With reference to FIG. 7A, when the head of the screw pin 170 is seated in the coupling hole 163a, rotating the screw pin 170 applies a force that pulls the fastening member 180 in the direction of the screw pin 170. Assuming the pulling force applied by the screw pin 170 on the fastening member 180 as initial stress A0, the initial stress applied to the fastening member 180 is dispersed radially by the stress dispersion unit 200. The radial distribution of the stress through the stress dispersion unit 200 weakens the strength of the initial stress A0.

That is, the initial stress A0 is dispersed by 1/n depending on the number (n) of supporting member 210 arranged along the outer circumference of the fastening member 180 and transmitted in the direction of the expansion member 230. Assuming the stress weakened by 1/n as the primary stress A1, the primary stress A1 is dispersed by the number of supporting member 210 and transmitted in the direction of the expansion member 230 as indicated by the arrow associated with A1 in FIG. 7A.

In addition, while the initial stress A0 is concentrated in the central part of the assembly, the primary stress A1 is dispersed through the supporting member 210 and spread over a wider area. This effect primarily disperses the stress concentration in terms of magnitude and direction through the supporting member 210. Stress is generally defined by the applied force over a given area. Thus, by widening the area of distribution of the initial stress A0 through the supporting members 210 and assuming a constant initial force, or constant initial stress A0, then the resulting primary stress A1 is less, and likely much less than the initial stress A0. In a non-limiting example, if the supporting members 210 have a width (w) that is the same as the width of the pin 170, then the resulting width (and area) of the combination of the supporting members 210 and the pin 170 is 2w. Applying the constant force or initial stress A0 from the pin 170 to twice the area results in a 50% decrease in stress relative to the pin 170 alone. As the supporting members 210 may be wider than the pin 170 in some embodiments, the difference in stress between A0 and A1 may be greater than 50% accordingly.

The expansion member 230 is connected in a cylindrical shape to the lower part of the supporting members 210, forming the stress-free space 235 in the central part. Accordingly, the primary stress A1 weakened by 1/n, which is transmitted from the supporting member 210, is not transmitted to the central part of the expansion member 230 where a stress-free space 235 is formed. Thus, the further weakened stress is transmitted radially in the direction of the expansion member 230 and applied to the set frame 140. It is noted that the further weakened stress is distributed to the set frame 140 in an area outside of the location of the pin 170. In other words, because of the design of the stress dispersion unit 200 described above, no stress is distributed to the set frame 140 and the cover glass 110 (i.e., via adhesive 130) at the location of the pin 170. Rather, a weakened stress is distributed over a large around the location of the pin 170. Such an arrangement differs significantly from the conventional fastening arrangement shown and described with reference to Figure 12.

As the stress passes through the expansion member 230, the primary stress A1 gradually spreads to an even wider area (i.e., area through and around expansion member 230) and is transmitted to the set frame 140 in a weakened state. Assuming the weakened stress as the secondary stress A2, the secondary stress A2 is dispersed even more widely than the primary stress A1 as indicated by the arrow associated with A2.

That is, the initial stress A0 concentrated at the center of the fastening member 180 is dispersed through the stress dispersion unit 200, resulting in a decrease in stress concentration from the wider area of the stress dispersion unit 200 and a weakening of the stress magnitude in the radial direction. This can alleviate the problem of localized deformation in specific areas of the cover member 110 caused by stress concentration at the locations of the fasteners described with reference to Figure 12 and further shown and described with respect to comparative examples below.

In particular, due to the stress-free space 235 formed at the center of the expansion member 230, the initial stress A0 is not transmitted to the central part associated with the pin 170, thus reducing the deformation of the cover member 110 caused by stress concentration at the joint between the core plate 160 and set frame 140 and/or at the locations of the fasteners.

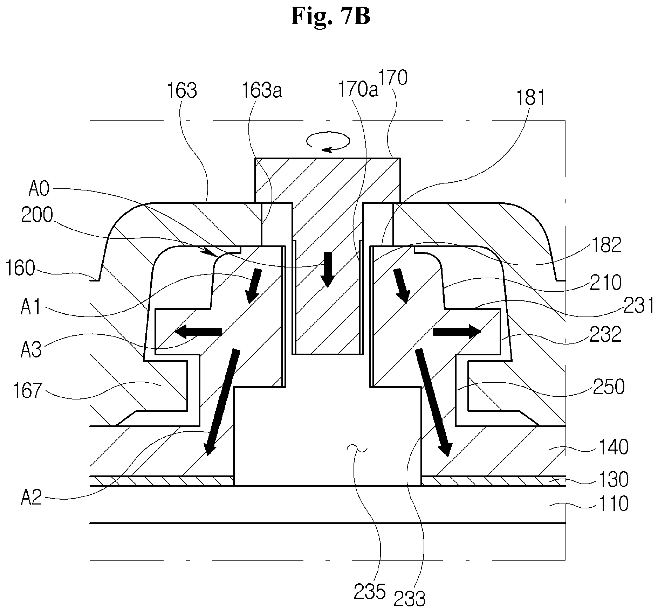

Meanwhile, FIG. 7B illustrates the structure of the stress dispersion unit 200 and the core plate 160 according to the second embodiment.

With reference to FIG. 7B, the stress dispersion unit 200 is disposed on the fastening member 180 and may disperse the stress applied to the cover member 110 when the fastening member 180 and the coupling block 163 with a screw.

The stress dispersion unit 200 may include a supporting member 210, an expansion member 230, a protrusion 250, and a stress-free space 235.

The expansion member 230 may be disposed below the fastening member 180 and have a shape expanded outward from the fastening member 180. In an embodiment of this disclosure, the expansion member 230 may have a cylindrical shape, but is not necessarily limited thereto.

The expansion member 230 may include an upper flange 231 and a side flange 232.

The upper flange 231 may be connected to the lower part of the fastening member 180 and have a shape expanded outward in the radial direction from the fastening member 180. The side flange 232 may be connected between the lower portion of the upper flange 231 and the set frame 140.

The stress-free space 235 may be formed inside the expansion member 230 and connected to the fastening hole 182 formed in the fastening member 180. The inner surface of the fastening hole 182 may be threaded. The fastening hole 182 may be fastened by screwing in a screw pin 170 having threads 170a machined on the outer surface thereof.

The supporting member 210 may be connected to the outer surface of the fastening member 180 and disposed on top of the upper flange 231. The supporting member 210 may be arranged in multiple quantities along the outer circumference of the fastening member 180 in the longitudinal direction of the fastening member 180.

The second embodiment of FIG. 7B differs from the first embodiment of FIGS. 5-7A in that a protrusion 250 is further included in the stress dispersion unit 200. The protrusion 250 may be arranged to protrude outward in the radial direction from the side flange 232 and may extend further from the body 181 of the fastening member 180 than the supporting members 210. The protrusion 250 may be substantially disc-shaped.

In this case, the coupling block 163 may protrude upward from the core plate 160 and form a shape enclosing the upper portion of the fastening member 180. The coupling block 163 may include a coupling hole 163a through which a screw pin 170 may pass and be fastened to the fastening hole 182 using a screwing method, thereby connecting the core plate 160 and the set frame 140.

The second embodiment of FIG. 7B further differs from the first embodiment of FIGS. 5-7A in that the core plate 160 further includes a protruding block 167. The protruding block 167 may be connected to the lower part of the coupling block 163, protrude in the direction of the side flange 232, and be disposed below the protrusion 250. The protruding block 167 may generally have a shape and arrangement that corresponds to the protrusion 150 in a nested or interdigitated arrangement.

As shown in FIG. 7B, when the head of the screw pin 170 is seated in the coupling hole 163a, rotating the screw pin 170 applies a force that pulls the fastening member 180 in the direction of the screw pin 170. Assuming the pulling force applied by the screw pin 170 on the fastening member 180 as initial stress A0, the initial stress applied to the fastening member 180 is dispersed radially by the stress dispersion unit 200, weakening strength.

That is, the initial stress A0 is dispersed by 1/n depending on the number (n) of supporting member 210 arranged along the outer circumference of the fastening member 180 and transmitted in the direction of the expansion member 230. Assuming the stress weakened by 1/n as the primary stress A1, the primary stress A1 is dispersed by the number of supporting member 210 and transmitted in the direction of the expansion member 230 as indicated by the arrow.

In addition, while the initial stress A0 is concentrated in the central part, the primary stress A1 is dispersed through the supporting member 210 and spread over a wider area. This effect disperses the stress concentration in terms of magnitude and direction through the supporting member 210 primarily.

The expansion member 230 is connected in a cylindrical shape to the lower part of the supporting members 210, forming the stress-free space 235 in the central part. Accordingly, the primary stress A1 weakened by 1/n, which is transmitted from the supporting member 210, is not transmitted to the central part of the expansion member 230 where a stress-free space 235 is formed, but is transmitted radially in the direction of the expansion member 230 and applied to the set frame 140.

As it passes through the expansion member 230, the primary stress A1 gradually spreads and is transmitted to the set frame 140 in a weakened state. Assuming the weakened stress as the secondary stress A2, the secondary stress A2 is dispersed even more widely than the primary stress A1 as indicated by the arrow.

In the second embodiment, the initial stress A0 may also be dispersed through the protrusion portion 250. The primary stress A1 is also dispersed through the protrusion portion 250, which is connected outward in the radial direction of the side flange 232. That is, the primary stress A1 is dispersed through both the protrusion 250 and the expansion member 230. The protrusion portion 250, which again may be implemented as a ring or disk extending outward from the body 181 of the fastening member 180, further widens the area of distribution of the stress, thereby further weakening the stress relative to the embodiment of FIGS. 5-7A according to the concepts discussed above.

The secondary stress A2 is dispersed through the expansion member 230, while the tertiary stress A3 is dispersed through the protrusion 250. In this case, the tensile force in the second embodiment for the secondary stress A2 is reduced compared to that in the first embodiment, as the third stress A3 is excluded.

This can reduce the deformation of the set frame 140 and further decrease the deformation of the cover member 110.

That is, the initial stress A0 concentrated at the center of the fastening member 180 is dispersed through the stress dispersion unit 200, resulting in a decrease in stress concentration and a weakening of the stress magnitude in the radial direction. This can alleviate the problem of localized deformation in specific areas of the cover member 110 caused by stress concentration.

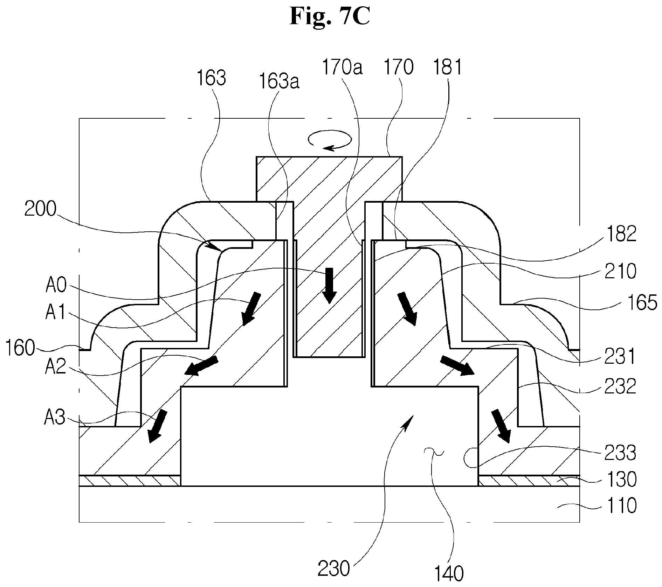

Meanwhile, FIG. 7C illustrates the structure of the stress dispersion unit 200 and the core plate 160 according to the third embodiment.

The third embodiment of FIG. 7C differs from the first embodiment of FIGS. 5-7A in that the upper flange 231 is further expanded outward in the radial direction relative to the body 181 of the fastening member 180 than the expansion member 230 of the FIGS. 5-7A.

In this case, the initial stress A0 is dispersed on the supporting member 210 to be the primary stress A1, which is then transformed into the secondary stress A2 on the upper flange 231 and further spreads and disperses outward in the radial direction. Afterward, it is transmitted along the side flange 232 to the set frame 140 as the tertiary stress A3.

Although the difference in tensile force between the secondary stress A2 and the tertiary stress A3 may not be significant, it can be expected that the stress concentration is further reduced in terms of a wider radial range (i.e., larger area) where stress dispersion occurs compared to the first embodiment of FIGS. 5-7A.

In this case, the core plate 160 may further include an extension block 165 enclosing the expansion member 230 expanded outward in the radial direction.

The extension block 165 may be connected to the lower part of the coupling block 163 and disposed to enclose the upper flange 231 and the side flange 232.

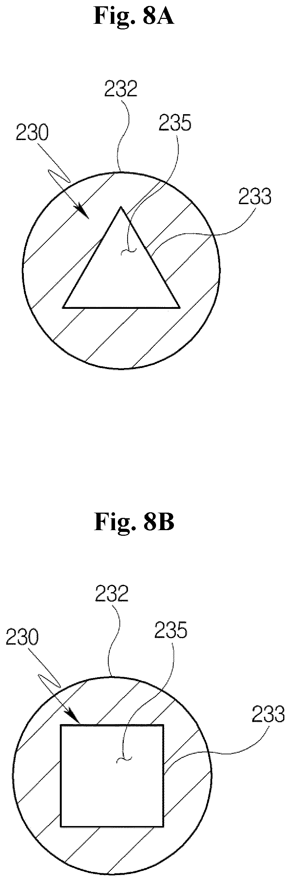

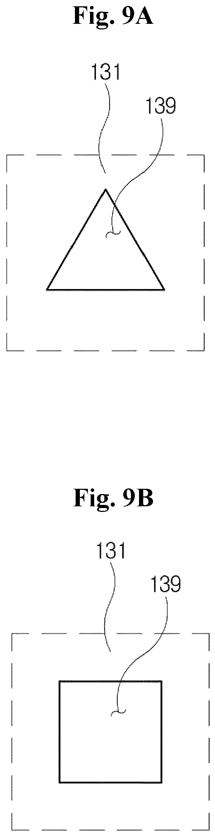

Meanwhile, FIGS. 8A to 8D illustrate various shapes of the expansion member 230 of the stress dispersion unit 200 according to the embodiments of this disclosure. Meanwhile, FIGS. 9A to 9D illustrate various shapes of the portion, which corresponds to the expansion member 230, in the adhesive member 130 according to the embodiments of this disclosure.

As shown in FIG. 8A, the expansion member 230 may have a circular outer perimeter, and the stress-free space 235 may have a triangular shape inside. As shown in FIG. 9A, the non-adhesive area 131 is formed by cutting off the adhesive member 130 to correspond in shape to the stress-free space 235 shown in FIG. 8A. This is because the stress-free space 235 is open, eliminating the need for adhesion between the cover member 110 and the set frame 140 therein.

Based on the first embodiment shown in FIG. 7A, the initial stress A0 is dispersed and weakened into the primary stress A1 on the supporting member 210, and the primary stress A1 further disperses outward in the radial direction as the secondary stress A2 on the expansion member 230 and is applied to the set frame 140.

When the inner side 233 forms a triangular shape, the secondary stress A2 may be distributed across three compartments, facilitating its dispersion.

As shown in FIG. 8B, the expansion member 230 may have a circular outer perimeter, and the stress-free space 235 may have a square shape internally.

As shown in FIG. 9B, the non-adhesive area 131 is formed by cutting off the adhesive member 130 to correspond in shape to the stress-free space 235 shown in FIG. 8B. This is because the stress-free space 235 is open, eliminating the need for adhesion between the cover member 110 and the set frame 140 therein.

Based on the first embodiment shown in FIG. 7A, the initial stress A0 is dispersed and weakened into the primary stress A1 on the supporting member 210, and the primary stress A1 further disperses outward in the radial direction as the secondary stress A2 on the expansion member 230 and is applied to the set frame 140.

When the inner side 233 forms a square shape, the secondary stress A2 may be distributed across four compartments, facilitating its dispersion.

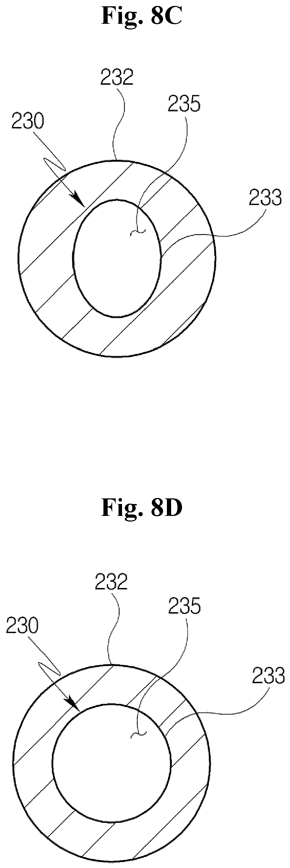

As shown in FIG. 8C, the expansion member 230 may have a circular outer perimeter, and the stress-free space 235 may have an elliptical shape inside.

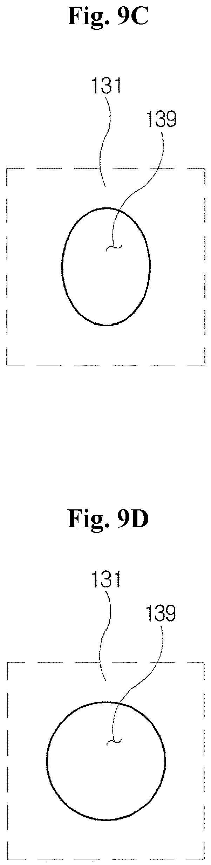

As shown in FIG. 9C, the non-adhesive area 131 is formed by cutting off the adhesive member 130 to correspond in shape to the stress-free space 235 shown in FIG. 8C. This is because the stress-free space 235 is open, eliminating the need for adhesion between the cover member 110 and the set frame 140 therein.

Based on the first embodiment shown in FIG. 7A, the initial stress A0 is dispersed and weakened into the primary stress A1 on the supporting member 210, and the primary stress A1 further disperses outward in the radial direction as the secondary stress A2 on the expansion member 230 and is applied to the set frame 140.

In this case, when the inner side 233 forms an elliptical shape, the secondary stress A2 is dispersed across a pair of areas along the major axis of the elliptical shape and applied to the set frame 140.

As shown in FIG. 8D, the expansion member 230 may have a circular outer perimeter, and the stress-free space 235 may have a circular shape inside.

As shown in FIG. 9D, the non-adhesive area 131 is formed by cutting off the adhesive member 130 to correspond in shape to the stress-free space 235 shown in FIG. 8D. This is because the stress-free space 235 is open, eliminating the need for adhesion between the cover member 110 and the set frame 140 therein.

Based on the first embodiment shown in FIG. 7A, the initial stress A0 is dispersed and weakened into the primary stress A1 on the supporting member 210, and the primary stress A1 further disperses outward in the radial direction as the secondary stress A2 on the expansion member 230 and is applied to the set frame 140.

When the inner side 233 forms a circular shape, the secondary stress A2 may be evenly dispersed in the radial direction.

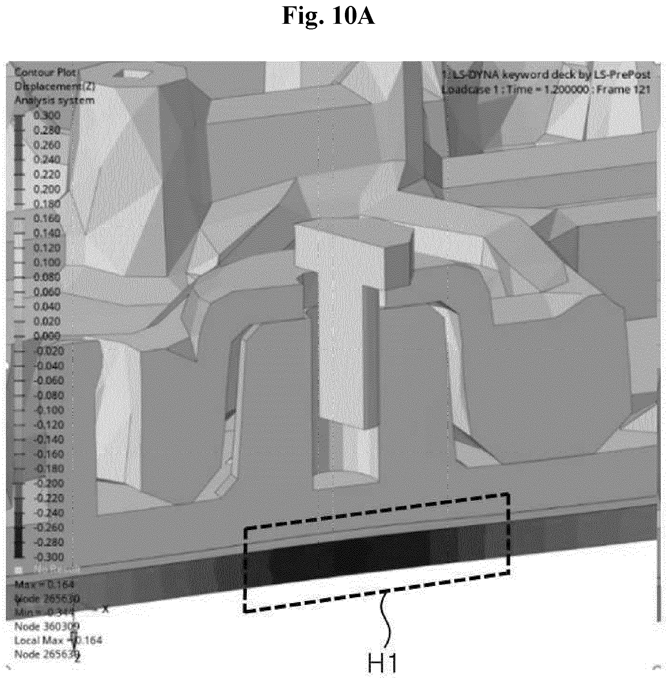

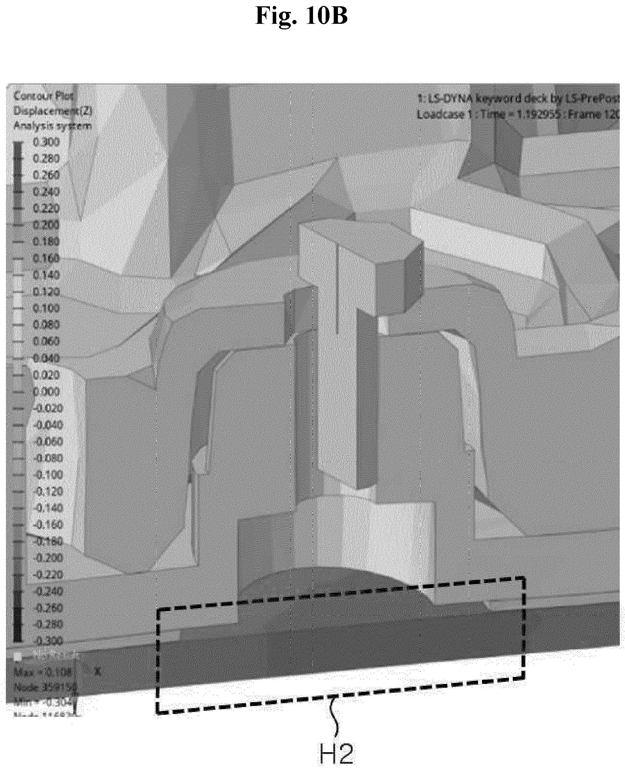

FIG. 10A shows stress distribution in the cover glass 1 when a conventional set frame 3 and core plate 4 are fastened (such as in FIG. 12), and FIG. 10B shows stress distribution in the cover glass when a set frame and core plate are fastened according to an embodiment of the present disclosure.

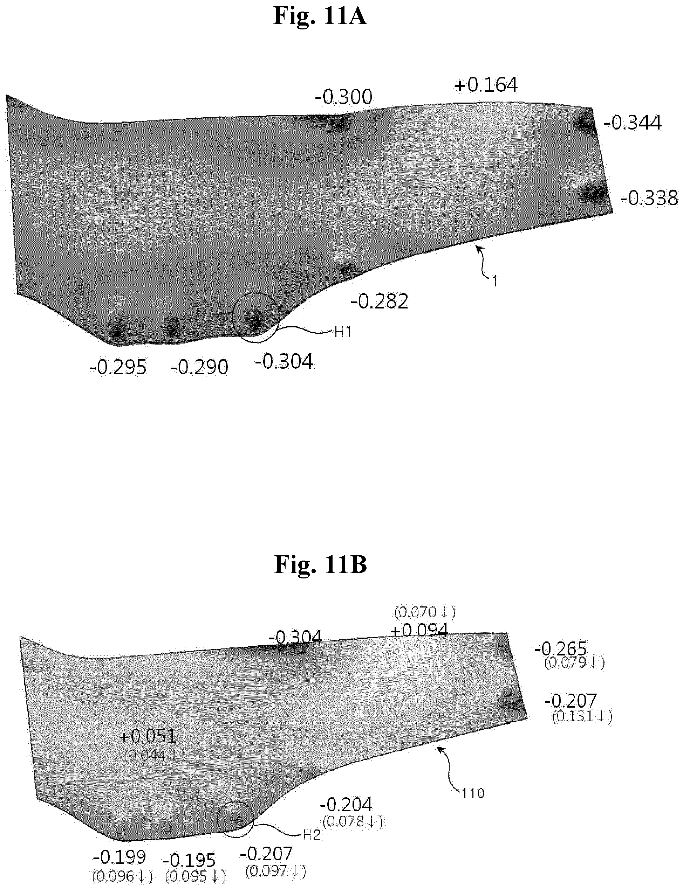

FIG. 11A shows stress distribution formed at the fastening area along the edge of a conventional cover glass 1 (such as in FIG. 12), FIG. 11B shows stress distribution formed at the fastening area along the edge of the cover glass according to an embodiment of this disclosure.

As described above, the conventional fastening structure depicted in FIG. 12 applies tensile force B1 to the oint portion 5a by the bolt 6 when fastening the bolt 6 into the bolt hole 5, resulting in the transfer of the tensile force B1 to the set frame 3 as stress B2. In this case, the cover glass 1 coupled to the set frame 3 with resin 2 experiences tensile stress in the direction of the bolt 6 at the corresponding location of the fastening area, F region, resulting in significant deformation at the joint portion between the core plate 4 and the set frame 3 and at a location that closely corresponds to the location of the bolt 6. In other words, in a conventional arrangement, all of the stress from fastening the bolt 6 is concentrated to a small area (i.e., region F) on the cover glass 1 that is generally aligned with the location of the bolt 6, and can result in deformation accordingly.

The stress dispersion unit 200 described in the embodiments forms a stress-free space 235 at the joint portion between the core plate 160 and the set frame 140 and allows for the radial dispersion of the initial stress A0 through the supporting member 210 and the expansion member 230, thereby reducing stress concentration and minimizing deformation of the cover member 110.

With reference to FIGS. 10A to 11B, a comparison is made between the conventional fastening structure and the fastening structure with the stress dispersion unit 200 according to the embodiment of this disclosure.

FIG. 10A, which presents experimental data based on the conventional fastening structure shown in FIG. 12, demonstrates that a tensile force generated, when fastening the bolt 6 to the joint portion 5a, causes a stress to occur in the H1 area of the cover glass 1, leading to deformation in the direction of the bolt 6.

In this case, since the stress is concentrated in the joint portion, the H1 area is represented in a darker shading. This indicates that the area is subjected to significant stress.

In contrast, FIG. 10B presents experimental data based on the fastening structure with the stress dispersion unit 200 formed according to the embodiment of this disclosure. As described above, when the screw pin 170 is fastened to the fastening member 180, the initial stress A0 generated by the fastening force of the screw pin 170 is dispersed and mitigated radially along the supporting member 210 and the expansion member 230, and the presence of an open stress-free space 235 at the center of the expansion member 230 helps alleviate the occurrence of stress in the H2 area of the cover member 110. This is represented in a relatively lighter shading, and compared to FIG. 10A, it can be observed through the colors that the stress has significantly reduced.

The H1 area shown in FIG. 11A corresponds to the H1 area shown in FIG. 10A and, with reference to FIG. 11A, it can be observed that stress is concentrated in the joint portion between the bolt 6 and the fastening portion 5a on the cover glass 1 as shown by the darker shading localized to the locations of the fasteners.

Here, the joint portion is provided in multiple quantities, and the unit of deformation for each is in millimeters.

For example, the deformation in the H1 area of the cover glass 1 is approximately -0.304 mm.

Here, the negative sign indicates that the deformation occurred inward in the direction toward the ground because FIG. 11A is illustrating the front side of the cover glass 1.

The H2 area shown in FIG. 11B corresponds to the H2 area shown in FIG. 10B, and referring to FIG. 11A, it can be observed that the stress occurring in the joint portion between the screw pin 170 and the fastening member 180 on the cover member 110 is alleviated, as represented by lighter shading.

This can be confirmed by comparing the deformation values and colors to the corresponding ones in FIG. 11A.

By comparing the H1 area, represented by a relatively darker shade in FIG. 11A, with the H2 area, which is represented by a relatively lighter shade in FIG. 11B, it is possible to observe the alleviation of stress.

The deformation value of the cover member 110 in the H2 area is approximately -0.207 mm. This means that the deformation value is reduced by approximately 0.097 mm compared to the deformation valued in the H1 area, which corresponds to an approximately 38% reduction in stress. Such a reduction appreciably reduces deformation of the cover glass and display apparatus generally as a result of the fastening operation relative to conventional techniques.

Here, the negative sign indicates that the deformation occurred inward in the direction toward the ground because FIG. 11B is illustrating the front side of the cover member 110.

In conclusion, when the stress dispersion unit 200 is configured in the joint portion between the core plate 160 and the set frame 140 as shown in the embodiments of this disclosure, the concentration of stress in the joint portion is dispersed and mitigated compared to conventional methods. As a result, the reduction in deformation of the cover member 110, specifically at the joint portion, can enhance the quality and aesthetics of the display apparatus 100, ultimately leading to increased consumer satisfaction.

The above description merely illustrates a specific embodiment of the display apparatus.

Therefore, it should be noted that those skilled in the art can easily understand that this disclosure can be substituted or modified in various forms without departing from the scope of the claims below.

### DESCRIPTION OF REFERENCE NUMERALS

| | | | |
|---|---|---|---|
| 100: | display apparatus | | |
| 110: | cover member | 130: | adhesive member |
| 140: | set frame | 150: | display panel |
| 160: | core plate | 163: | coupling block |
| 165: | extension block | 167: | protruding block |
| 170: | screw pin | 180: | fastening member |
| 200: | stress dispersion unit | 210: | supporting member |
| 230: | expansion member | 231: | upper flange |
| 232: | side flange | 233: | inner side |
| 235: | stress-free space | 250: | protrusion |

## Claims

1. A display apparatus (100) comprising:
a display panel (150);
a cover member (110) disposed on a front surface of the display panel (150);
a set frame (140) arranged on a back surface of the cover member (110) and including a fastening member (180);
a core plate (160) arranged on a back surface of the set frame (140) and including a coupling block (163);
a fastener coupled to the coupling block and the fastening member to couple the set frame to the core plate; and
**characterized in that** the display apparatus (100) further comprises
a stress distribution device(200) arranged on the fastening member (180), the stress distribution device(200) configured to disperse stress applied to the cover member as a result of the coupling of the set frame to the core plate with the fastener and
**in that** the stress distribution device (200) comprises an expansion member (230) arranged at a lower portion of the fastening member (180) and expanded outward from the fastening member (180), a stress-free space (235) formed inside the expansion member (230) and a supporting member (210) connected to an outer surface of the fastening member (180) and disposed on top of an upper flange (321) of the expansion member (230).

2. The display apparatus (100) of claim 1, wherein the stress-free space (235) is in communication with a fastening hole (182) in the fastening member (180).

3. The display apparatus (100) of claim 2, wherein the upper flange (231) is connected to a lower portion of the fastening member (180) and expanded outward in a radial direction from the fastening member (180); and
the expansion member (230) further comprises a side flange (232) coupled to the upper flange, the side flange being between the lower portion of the upper flange (231) and the set frame (140).

4. The display apparatus (100) of claim 3, wherein the expansion member (230) is formed in a cylindrical shape.

5. The display apparatus (100) of claim 4, wherein the stress-free space (235) is formed inside the expansion member and has a circular or polygonal shape.

6. The display apparatus (100) of any one of claims 3 to 5, further comprising an adhesive member (130) arranged between the cover member (110) and the set frame (140) and bonding the cover member (110) to the set frame (140).

7. The display apparatus (100) of claim 6, wherein the cover member (110) comprises an active area (AA) corresponding in position to the display panel (150) and a non-active area (NA) outside the active area (AA) and the adhesive member (130) is arranged in the non-active area (NA).

8. The display apparatus (100) of claim 7, wherein the fastening member (180) and the coupling block (163) are arranged in the non-active area (NA).

9. The display apparatus (100) of any of claims 6 to 8, wherein the adhesive member (130) comprises a non-adhesive area (131) corresponding in shape to an interior shape of the stress-free space (235).

10. The display apparatus (100) of any of claims 3 to 9, wherein the stress distribution device(200) further comprises a protrusion (250) extending radially and protruding outward from the side flange (232).

11. The display apparatus (100) of claim 10, wherein the core plate (160) further comprises a protruding block (167) connected to a lower portion of the coupling block (163), protruding toward the side flange (232), and arranged on a lower portion of the protrusion (250).

12. The display apparatus (100) of any of claims 3 to 11, wherein the core plate (160) further comprises an extension block (165) connected to a lower portion of the coupling block (163) and arranged to enclose the upper flange (231) and the side flange (232).

## Patentansprüche

1. Anzeigevorrichtung (100), aufweisend:
ein Anzeigepanel (150),
ein Abdeckelement (110), das an einer Vorderfläche des Anzeigepanels (150) angeordnet ist,
einen Geräterahmen (140), der an einer rückwärtigen Fläche des Abdeckelements (110) angeordnet ist und ein Befestigungselement (180) aufweist,
eine Kernplatte (160), die an einer rückwärtigen Fläche des Geräterahmens (140) angeordnet ist und einen Verbindungsblock (163) aufweist,
eine Befestigungsvorrichtung, die mit dem Verbindungsblock und dem Befestigungselement verbunden ist, um den Geräterahmen mit der Kernplatte zu verbinden, und
**dadurch gekennzeichnet, dass** die Anzeigevorrichtung (100) ferner aufweist:
eine Spannungsverteilungsvorrichtung (200), die an dem Befestigungselement (180) angeordnet ist, wobei die Spannungsverteilungsvorrichtung (200) konfiguriert ist, um Spannung zu verteilen, die infolge des Verbindens des Geräterahmens mit der Kernplatte mit der Befestigungsvorrichtung auf das Abdeckelement ausgeübt wird, und
dass die Spannungsverteilungsvorrichtung (200) aufweist: ein Expansionselement (230), das an einem unteren Abschnitt des Befestigungselements (180) angeordnet ist und sich vom Befestigungselement (180) nach außen ausdehnt, einen innerhalb des Expansionselements (230) ausgebildeten spannungsfreien Raum (235) und ein Stützelement (210), das mit einer Außenfläche des Befestigungselements (180) verbunden ist und auf einem oberen Flansch (321) des Expansionselements (230) angeordnet ist.

2. Anzeigevorrichtung (100) gemäß Anspruch 1, wobei der spannungsfreie Raum (235) mit einem Befestigungsloch (182) im Befestigungselement (180) kommuniziert.

3. Anzeigevorrichtung (100) gemäß Anspruch 2, wobei der obere Flansch (231) mit einem unteren Abschnitt des Befestigungselements (180) verbunden ist und sich vom Befestigungselement (180) aus in einer radialen Richtung nach außen ausdehnt, und
das Expansionselement (230) ferner einen mit dem oberen Flansch verbundenen Seitenflansch (232) aufweist, wobei sich der Seitenflansch zwischen dem unteren Abschnitt des oberen Flansches (231) und dem Geräterahmen (140) befindet.

4. Anzeigevorrichtung (100) gemäß Anspruch 3, wobei das Expansionselement (230) in einer zylindrischen Form ausgebildet ist.

5. Anzeigevorrichtung (100) gemäß Anspruch 4, wobei der spannungsfreie Raum (235) innerhalb des Expansionselements ausgebildet ist und eine kreisförmige oder polygonale Form hat.

6. Anzeigevorrichtung (100) gemäß irgendeinem der Ansprüche 3 bis 5, ferner aufweisend ein Klebeelement (130), das zwischen dem Abdeckelement (110) und dem Geräterahmen (140) angeordnet ist und das Abdeckelement (110) mit dem Geräterahmen (140) verbindet.

7. Anzeigevorrichtung (100) gemäß Anspruch 6, wobei das Abdeckelement (110) einen aktiven Bereich (AA), der in seiner Position mit dem Anzeigepanel (150) korrespondiert, und einen nichtaktiven Bereich (NA) außerhalb des aktiven Bereichs (AA) aufweist und das Klebeelement (130) im nichtaktiven Bereich (NA) angeordnet ist.

8. Anzeigevorrichtung (100) gemäß Anspruch 7, wobei das Befestigungselement (180) und der Verbindungsblock (163) im nichtaktiven Bereich (NA) angeordnet sind.

9. Anzeigevorrichtung (100) gemäß irgendeinem der Ansprüche 6 bis 8, wobei das Klebeelement (130) einen nichtklebenden Bereich (131) aufweist, dessen Form mit einer Innenform des spannungsfreien Raums (235) korrespondiert.

10. Anzeigevorrichtung (100) gemäß irgendeinem der Ansprüche 3 bis 9, wobei die Spannungsverteilungsvorrichtung (200) ferner einen Vorsprung (250) aufweist, der sich radial erstreckt und vom Seitenflansch (232) nach außen hervorsteht.

11. Anzeigevorrichtung (100) gemäß Anspruch 10, wobei die Kernplatte (160) ferner einen Vorsprungsblock (167) aufweist, der mit einem unteren Abschnitt des Verbindungsblocks (163) verbunden ist, in Richtung zum Seitenflansch (232) hervorsteht und an einem unteren Abschnitt des Vorsprungs (250) angeordnet ist.

12. Anzeigevorrichtung (100) gemäß irgendeinem der Ansprüche 3 bis 11, wobei die Kernplatte (160) ferner einen Verlängerungsblock (165) aufweist, der mit einem unteren Abschnitt des Verbindungsblocks (163) verbunden ist und angeordnet ist, um den oberen Flansch (231) und den Seitenflansch (232) zu umschließen.

## Revendications

1. Dispositif d'affichage (100), comprenant :
un panneau d'affichage (150) ;
un élément de recouvrement (110) disposé sur une surface avant du panneau d'affichage (150) ;
un cadre d'installation (140) agencé sur une surface arrière de l'élément de recouvrement (110) et comprenant un élément de fixation (180) ;
une plaque centrale (160) agencée sur une surface arrière du cadre d'installation (140) et comprenant un bloc d'accouplement (163) ;
un dispositif de fixation couplé au bloc d'accouplement et à l'élément de fixation pour accoupler le cadre d'installation à la plaque centrale ; et
**caractérisé en ce que** le dispositif d'affichage (100) comprend en outre :
un dispositif de répartition de contraintes (200) disposé sur l'élément de fixation (180), le dispositif de répartition de contraintes (200) étant configuré pour disperser les contraintes appliquées à l'élément de recouvrement à la suite de l'accouplement du cadre d'installation à la plaque centrale à l'aide du dispositif de fixation, et
**en ce que** le dispositif de répartition de contraintes (200) comprend un élément d'expansion (230) disposé au niveau d'une partie inférieure de l'élément de fixation (180) et expansé vers l'extérieur à partir de l'élément de fixation (180), un espace sans contrainte (235) formé à l'intérieur de l'élément d'expansion (230) et un élément de support (210) relié à une surface extérieure de l'élément de fixation (180) et disposé au-dessus d'une bride supérieure (321) de l'élément d'expansion (230).

2. Dispositif d'affichage (100) selon la revendication 1, dans lequel l'espace sans contrainte (235) communique avec un trou de fixation (182) dans l'élément de fixation (180).

3. Dispositif d'affichage (100) selon la revendication 2, dans lequel la bride supérieure (231) est reliée à une partie inférieure de l'élément de fixation (180) et s'étend vers l'extérieur dans une direction radiale à partir de l'élément de fixation (180) ; et
l'élément d'expansion (230) comprend en outre une bride latérale (232) couplée à la bride supérieure, la bride latérale étant située entre la partie inférieure de la bride supérieure (231) et le cadre d'installation (140).

4. Dispositif d'affichage (100) selon la revendication 3, dans lequel l'élément d'expansion (230) est formé en une forme cylindrique.

5. Dispositif d'affichage (100) selon la revendication 4, dans lequel l'espace sans contrainte (235) est formé à l'intérieur de l'élément d'expansion et présente une forme circulaire ou polygonale.

6. Dispositif d'affichage (100) selon l'une quelconque des revendications 3 à 5, comprenant en outre un élément adhésif (130) disposé entre l'élément de recouvrement (110) et le cadre d'installation (140) et reliant l'élément de recouvrement (110) au cadre d'installation (140).

7. Dispositif d'affichage (100) selon la revendication 6, dans lequel l'élément de recouvrement (110) comprend une zone active (AA) dont la position correspond à celle du panneau d'affichage (150) et une zone non active (NA) située à l'extérieur de la zone active (AA), et l'élément adhésif (130) est disposé dans la zone non active (NA).

8. Dispositif d'affichage (100) selon la revendication 7, dans lequel l'élément de fixation (180) et le bloc d'accouplement (163) sont disposés dans la zone non active (NA).

9. Dispositif d'affichage (100) selon l'une quelconque des revendications 6 à 8, dans lequel l'élément adhésif (130) comprend une zone non adhésive (131) dont la forme correspond à une forme intérieure de l'espace sans contrainte (235).

10. Dispositif d'affichage (100) selon l'une quelconque des revendications 3 à 9, dans lequel le dispositif de répartition de contraintes (200) comprend en outre une saillie (250) s'étendant radialement et faisant saillie vers l'extérieur à partir de la bride latérale (232).

11. Dispositif d'affichage (100) selon la revendication 10, dans lequel la plaque centrale (160) comprend en outre un bloc en saillie (167) relié à une partie inférieure du bloc d'accouplement (163), faisant saillie vers la bride latérale (232), et disposé sur une partie inférieure de la saillie (250).

12. Dispositif d'affichage (100) selon l'une quelconque des revendications 3 à 11, dans lequel la plaque centrale (160) comprend en outre un bloc d'extension (165) relié à une partie inférieure du bloc d'accouplement (163) et agencé de manière à entourer la bride supérieure (231) et la bride latérale (232).
